# EUROPEAN PATENT SPECIFICATION

(11) **EP 2 528 109 B1**
(45) Date of publication and mention of the grant of the patent: **16.12.2015**
(21) Application number: 11008512.3
(22) Date of filing: 24.10.2011
(51) Int. Cl.: H01L 31/05

(54) **Solar cell module**
Solarzellenmodul
Module de cellule solaire

(30) Priority: 26.05.2011 KR 20110049975
(43) Date of publication of application: 28.11.2012
(73) Proprietor: LG ELECTRONICS INC., Yeongdeungpo-gu Seoul 150-721 (KR)
(72) Inventor: Hong, Jongkyoung, Seoul 137-724 (KR); Kim, Taeyoon, Seoul 137-724 (KR); Lee, Eunjoo, Seoul 137-724 (KR); Mun, Seiyoung, Seoul 137-724 (KR); Yu, Jemin, Seoul 137-724 (KR); Woo, Taeki, Seoul 137-724 (KR)
(74) Representative: Katérle, Axel

(56) References cited:
- EP-A1- 2 012 364
- EP-A1- 2 058 868
- EP-A1- 2 068 372
- US-A1- 2008 121 266

## Description

### BACKGROUNG OF THE INVENTION

### Field of the Invention

Embodiments of the invention relate to a solar cell module in which adjacent solar cells are electrically connected to one another using an interconnector.

### Description of the Related Art

Solar power generation to convert light energy into electric energy using a photoelectric conversion effect has been widely used as a method for obtaining eco-friendly energy. A solar power generation system using a plurality of solar cell modules has been installed in places, such as houses due to an improvement of a photoelectric conversion efficiency of solar cells.

In a solar cell module, electric power produced by the solar cells is output to the outside of the solar cell module by connecting a conductive element (for example, an interconnector) connected to an anode and a cathode of each of the solar cells to lead wires to extend the conductive element to the outside of the solar cell module, and connecting the lead wires to a junction box to extract electric current through a power supply line of the junction box.

EP 2068372 A1 relates to a solar cell module in which a plurality of solar cells are provided between a front surface protection member and a back surface protection member and bus bar electrodes of the plurality of solar cells are electrically connected to each other by wiring members.

The present invention provides a solar cell module according to independent claim 1. Further improvements to the solar cell module are recited in the dependent claims.

### SUMMARY OF THE INVENTION

In one aspect, there is a solar cell module including a plurality of solar cells, each of the plurality of solar cells including a substrate and an electrode part positioned on the substrate, an interconnector configured to electrically connect adjacent solar cells of the plurality of solar cells to each other, and a conductive adhesive film positioned between the electrode part of each solar cell and the interconnector, the conductive adhesive film electrically connecting the electrode part of each solar cell to the interconnector.

The conductive adhesive film includes a resin having a first thickness in an overlap area of the conductive adhesive film, the electrode part and the interconnector, and having conductive particles, which are dispersed in the resin, wherein each of the conductive particles have irregular shapes.

The conductive particles may have thicknesses that are greater than the first thickness. Other conductive particles have thickness that are less than the first thickness, and the first thickness is a sum of thicknesses of at least two overlapping conductive particles. A distance between the interconnector and the electrode part is kept at the first thickness.

The substrate may have a thickness of about 80 µm to 180 µm.

The first thickness of the resin is about 3 µm to 15 µm, and the thickness of the conductive particles is about 3 µm to 15 µm.

The conductive particles may be formed of circular or oval metal-coated resin particles containing at least one metal selected among copper (Cu), silver (Ag), gold (Au), iron (Fe), nickel (Ni), lead (Pb), zinc (Zn), cobalt (Co), titanium (Ti), and magnesium (Mg) as the main component.

When the conductive particles are formed of the circular or oval metal-coated resin particles, the thickness of the conductive particle may be expressed by a diameter of the metal-coated resin particle or a diameter of the metal-coated resin particle in a short axis direction.

The conductive particles may be formed of radical metal particles containing at least one metal selected among copper (Cu), silver (Ag), gold (Au), iron (Fe), nickel (Ni), lead (Pb), zinc (Zn), cobalt (Co), titanium (Ti), and magnesium (Mg) as the main component.

The radical metal particle may indicate a particle in which a plurality of projections are non-uniformly formed on the surface of the metal particle having a shape like a sphere.

When the conductive particles are formed of the radical metal particles, the thickness of the conductive particle may be expressed by a shortest diameter measured from a shape like a sphere defined by a virtual line for connecting ends of the plurality of projections formed on the surface of the metal particle to one another.

When the at least two radical metal particles are stacked, the thickness of the conductive particles may expressed by a sum of the shortest diameters of the at least two radical metal particles.

According to the above-described configuration, the conductive particles directly contact at least one of the interconnector and the electrode part. Some of the conductive particles may be embedded in at least one of the interconnector and the electrode part. Thus, because carriers collected by the electrode part are directly transferred to the interconnector through the conductive particles, current transfer efficiency is improved.

The interconnector may include a conductive metal formed of a lead-free material containing lead (Pb) equal to or less than about 1,000 ppm and a solder formed of a Pb-containing material coated on the surface of the conductive metal. Alternatively, the interconnector may include only a conductive metal formed of a lead-free material containing lead (Pb) equal to or less than about 1,000 ppm.

The surface of the electrode part may be an even surface or an uneven surface having a plurality of uneven portions.

The electrode part may include a plurality of first electrodes positioned on a first surface of the substrate. In this instance, the conductive adhesive film is positioned in a direction crossing the plurality of first electrodes and covers a portion of an upper surface and both sides of each of the plurality of first electrodes and a space between the plurality of first electrodes.

The resin may have a second thickness greater than the first thickness in a non-overlap area between the conductive adhesive film and the plurality of first electrodes.

The thickness of the conductive particles may be less than the second thickness.

The electrode part may include a plurality of first electrodes positioned on a first surface of the substrate and a plurality of first electrode current collectors crossing the plurality of first electrodes. In this instance, the conductive adhesive film is positioned on the plurality of first electrode current collectors in a direction parallel to the plurality of first electrode current collectors

The electrode part may include a second electrode positioned on a second surface of the substrate. The second electrode may be formed on the entire second surface of the substrate or may be formed on the entire second surface of the substrate except edges of the second surface of the substrate. In this instance, the conductive adhesive film directly contacts the second electrode.

The electrode part may include a second electrode positioned on a second surface of the substrate and a second electrode current collector electrically connected to the second electrode. In this instance, the conductive adhesive film directly contacts the second electrode current collector.

According to the above-described configuration, carriers moving to the electrode part, for example, the first electrodes, the first electrode current collectors, the second electrode, or the second electrode current collector are transferred to the interconnector through the conductive particles of the conductive adhesive film.

In this instance, because the conductive particles are embedded in the interconnector, a contact area between the conductive particles and the interconnector increases. Hence, the current transfer efficiency and the reliability are improved.

Further, a tabbing process may be performed at a low temperature because of the use of the conductive adhesive film.

A related art tabbing process through a soldering method using flux is performed at a temperature equal to or higher than about 220 °C. On the other hand, because the tabbing process using the conductive adhesive film uses not the soldering method but a bonding method, the tabbing process may be performed at a temperature equal to or lower than about 180 °C. Thus, a warp phenomenon of the substrate generated in the tabbing process may be greatly reduced, compared with the related art tabbing process.

For example, when a thickness of the substrate is about 200 µm, a warp amount of the substrate is equal to or greater than about 2.1 mm in the related art tabbing process for melting flux using a hot air. On the other hand, a warp amount of the substrate is about 0.5 mm in the tabbing process using the conductive adhesive film.

The warp amount of the substrate may be expressed by a difference between heights of a middle portion and a peripheral portion of the second surface of the substrate.

The warp amount of the substrate increases as the thickness of the substrate decreases. For example, the thickness of the substrate is about 80 µm, the warp amount of the substrate is equal to or greater than about 14 mm in the related art tabbing process. On the other hand, the warp amount of the substrate is about 1.8 mm in the tabbing process using the conductive adhesive film.

When the warp amount of the substrate exceeds a predetermined value, for example, about 2.5 mm, a crack is generated in the substrate or bubbles are generated in the solar cell module in a subsequent lamination process. Therefore, it is impossible to use a thin substrate in the related art solar cell module manufactured using the related art tabbing process.

On the other hand, the tabbing process using the conductive adhesive film may greatly reduce the warp amount of the substrate, compared with the related art tabbing process. Hence, the solar cell module may use the thin substrate.

For example, the substrate having the thickness of about 80 µm to 180 µm may be manufactured through the tabbing process using the conductive adhesive film. Thus, the material cost may be reduced because of a reduction in the thickness of the substrate.

The crack may occur at an interface between the electrode part and the interconnector in the related art tabbing process, or a peeling phenomenon between several materials may occur inside the solder of the interconnector. Hence, the output of the related art solar cell module may be reduced. On the other hand, the problems may be solved due to the tabbing process using the conductive adhesive film. Thus, the reliability of the solar cell module is improved.

Further, because the flux is not used in the tabbing process using the conductive adhesive film, an adhesive strength may be uniformly held, and a misalignment may be prevented or reduced. Hence, a reduction in the output of the solar cell module may be prevented or reduced.

### BRIEF DESCRIPTION OF THE DRAWINGS

The accompanying drawings, which are included to provide a further understanding of the invention and are incorporated in and constitute a part of this specification, illustrate embodiments of the invention and together with the description serve to explain the principles of the invention. In the drawings:
FIG. 1 is a plane view of a solar cell module according to an example embodiment of the invention;
FIG. 2 is an exploded perspective view of a solar cell panel shown in FIG. 1;
FIG. 3 is a side view of a solar cell panel shown in FIG. 1;
FIG. 4 is an exploded perspective view of a solar cell panel according to a first embodiment of the invention;
FIGS. 5 to 7 are cross-sectional views illustrating various assembly configurations of a front surface of a substrate in the solar cell panel shown in FIG. 4;
FIG. 8 is an enlarged depiction of an example conductive particle used in the configuration illustrated in FIG. 6;
FIGS. 9 to 11 are plane views of a front surface of a substrate illustrating various configurations of an electrode part positioned on a first surface of the substrate in the solar cell panel shown in FIG. 4;
FIG. 12 is an exploded perspective view of a solar cell panel according to a second embodiment of the invention;
FIGS. 13 and 14 are cross-sectional views illustrating various assembly configurations of a front surface of a substrate in the solar cell panel shown in FIG. 12;
FIG. 15 is a plane view of a front surface of a substrate illustrating various configurations of an electrode part positioned on a first surface of the substrate in the solar cell panel shown in FIG. 12;
FIG. 16 is a cross-sectional view illustrating various assembly configurations of a back surface of a substrate of the solar cell panel shown in FIG. 12;
FIGS. 17 and 18 are plane views of a back surface of a substrate illustrating various configurations of an electrode part positioned on a second surface of the substrate in the solar cell panel shown in FIG. 12;
FIG. 19 is a plane view of a solar cell panel according to a third embodiment of the invention;
FIG. 20 is a partial cross-sectional view of the solar cell panel shown in FIG. 19; and
FIG. 21 is a side view of a HIT (Heterojunction with Intrinsic Thin layer) solar cell used in a solar cell panel according to a fourth embodiment of the invention.

### DETAILED DESCRIPTION OF THE EMBODIMENTS

Embodiments of the invention will be described more fully hereinafter with reference to the accompanying drawings, in which example embodiments of the invention are shown. This invention may, however, be embodied in many different forms and should not be construed as limited to the embodiments set forth herein.

In the drawings, the thickness of layers, films, panels, regions, etc., are exaggerated for clarity. Like reference numerals designate like elements throughout the specification. It will be understood that when an element such as a layer, film, region, or substrate is referred to as being "on" another element, it can be directly on the other element or intervening elements may also be present. In contrast, when an element is referred to as being "directly on" another element, there are no intervening elements present. Further, it will be understood that when an element such as a layer, film, region, or substrate is referred to as being "entirely" on another element, it may be on the entire surface of the other element and may not be on a portion of an edge of the other element.

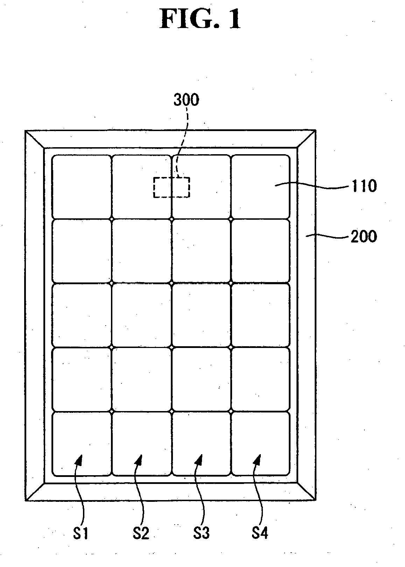

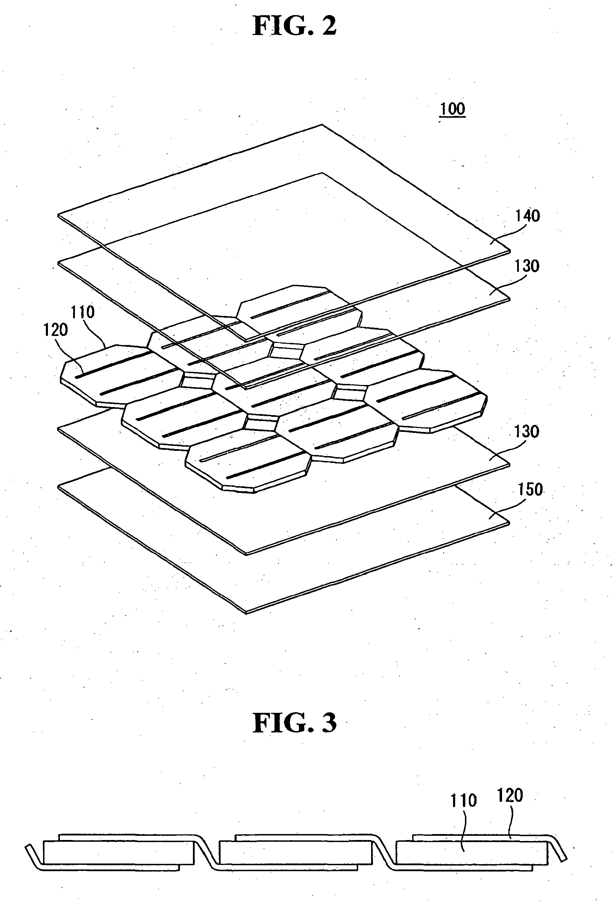

FIG. 1 is a plane view of a solar cell module according to an example embodiment of the invention. FIG. 2 is an exploded perspective view of a solar cell panel shown in FIG. 1. FIG. 3 is a side view of a solar cell panel shown in FIG. 1.

In the example embodiment of the invention, the solar cell module according to the example embodiment of the invention includes a solar cell panel 100.

As shown in FIG. 2, the solar cell panel 100 includes a plurality of solar cells 110, interconnectors 120 for electrically connecting the solar cells 110 to one another, protective layers 130 for protecting the solar cells 110, a transparent member 140 positioned on the protective layer 130 on light receiving surfaces of the solar cells 110, and a back sheet 150 which is positioned under the protective layer 130 on surfaces opposite the light receiving surfaces of the solar cells 110 and which is formed of an opaque material.

As shown in FIG. 1, the solar cell module includes a frame 200 receiving the components 110, 120, 130, 140, and 150, which form an integral body through a lamination process, and a junction box 300 for collecting electric power produced by the solar cells 110.

The back sheet 150 prevents moisture or oxygen from penetrating into a back surface of the solar cell panel 100, thereby protecting the solar cells 110 from an external environment. The back sheet 150 may have a multi-layered structure including a moisture/oxygen penetrating prevention layer, a chemical corrosion prevention layer, a layer having insulating characteristics, etc.

The protective layers 130 and the solar cells 110 form an integral body when a lamination process is performed in a state where the protective layers 130 are respectively positioned on and under the solar cells 110. The protective layers 130 prevent corrosion of metal resulting from the moisture penetration and protect the solar cells 110 from an impact. The protective layers 130 may be formed of a material such as ethylene vinyl acetate (EVA). Other materials may be used.

The transparent member 140 on the protective layer 130 is formed, for example, of a tempered glass having a high light transmittance and excellent damage prevention characteristic. The tempered glass may be a low iron tempered glass containing a small amount of iron. The transparent member 40 may have an embossed inner surface so as to increase a scattering effect of light.

An electrical connection structure of the solar cell panel included in the solar cell module according to the example embodiment of the invention is described in detail below with reference to FIGS. 2 and 3. FIG. 3 is an enlarged diagram of a distance between the solar cells 110. The solar cells 110 are spaced apart from one another at a predetermined distance, for example, a narrow distance less than about 3 mm.

As shown in FIG. 1, the plurality of solar cells 110 included in the solar cell panel 100 are arranged in the form of strings. The string refers to the plurality of solar cells 110, which are arranged in a row and is electrically connected to one another. Thus, the solar cell panel 100 is shown with four strings, for example, first to fourth strings S 1 to S4.

The solar cells 110 arranged in each of the strings S 1 to S4 are electrically connected to one another using the interconnectors 120.

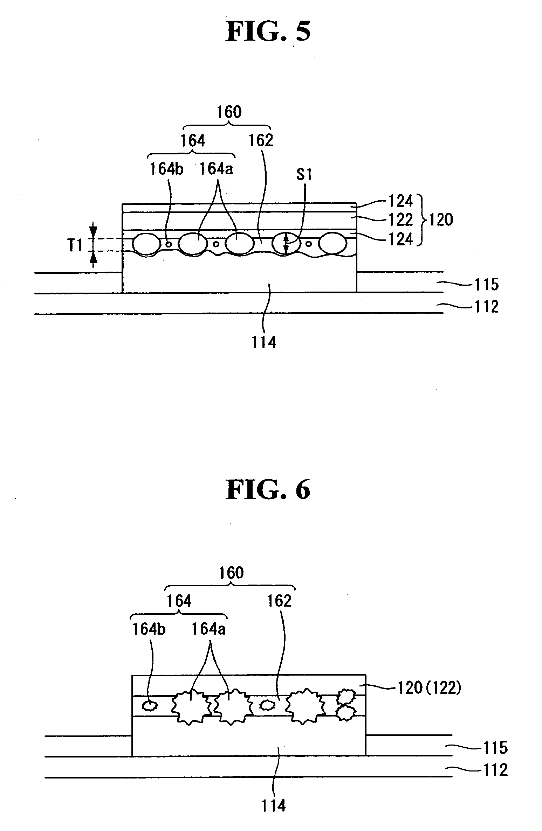

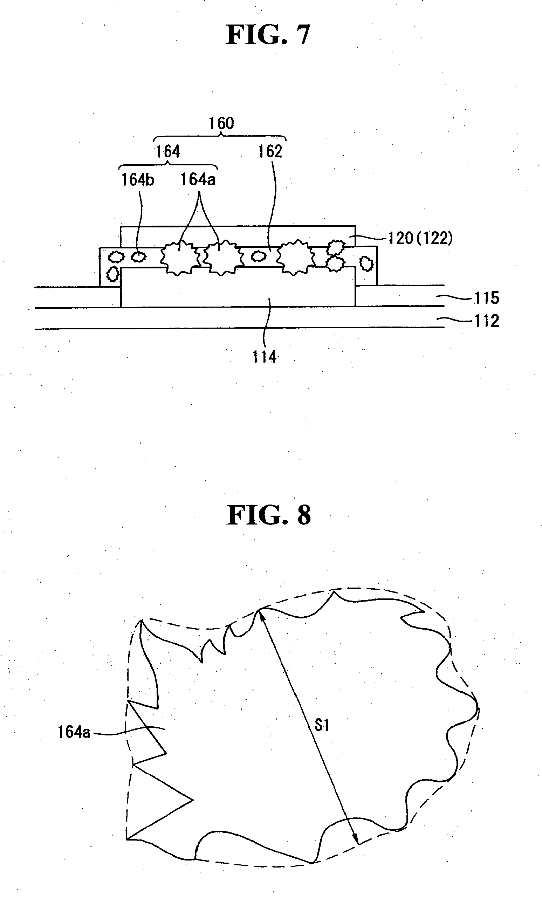

As shown in FIG. 5, the interconnector 120 may include a conductive metal 122 formed of a lead-free material containing lead (Pb) equal to or less than about 1,000 ppm and a solder 124 formed of a Pb-containing material coated on the surface of the conductive metal 122. Alternatively, as shown in FIGS. 6 and 7, the interconnector 120 may include only a conductive metal 122 formed of a lead-free material containing lead equal to or less than about 1,000 ppm.

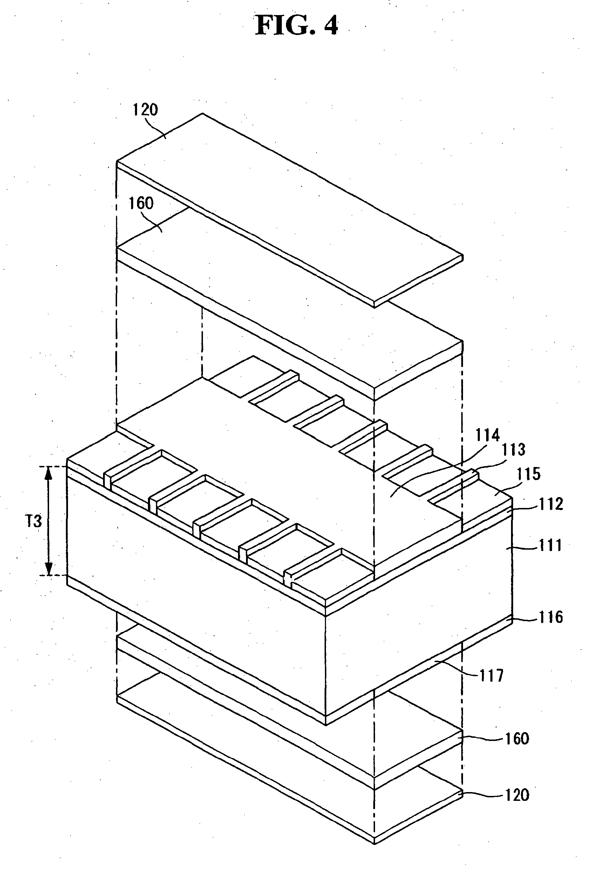

In one string, for example, in the first string S1, a first electrode current collector 114 (refer to FIGS. 4 and 5) of one of the solar cells 110, which are positioned adjacent to one another in a longitudinal direction, is electrically connected to a second electrode current collector 117 (refer to FIGS. 4 and 5) of another solar cell 110 adjacent to the one solar cell 110 using the interconnector 120.

A lead wire for connecting the interconnectors 120 positioned at ends of the adjacent strings to one another may include a conductive metal formed of a lead-free material containing lead (Pb) equal to or less than about 1,000 ppm and a solder formed of a Pb-containing material coated on the surface of the conductive metal, or may include only a conductive metal formed of a lead-free material containing Pb equal to or less than about 1,000 ppm, in the same manner as the interconnector 120.

A connection structure between electrodes of the solar cells and the interconnector is described in detail below with reference to FIGS. 4 to 7.

FIG. 4 is an exploded perspective view of a solar cell panel according to a first embodiment of the invention. FIGS. 5 to 7 are cross-sectional views illustrating various assembly configurations of a front surface of a substrate in the solar cell panel shown in FIG. 4.

The solar cell 110 according to the first embodiment of the invention includes a substrate 111, an emitter layer 112 positioned at a first surface (i.e., a front surface on which light is incident) of the substrate 111, a plurality of first electrodes 113 and a plurality of first electrode current collectors 114 positioned on the emitter layer 112, an anti-reflection layer 115 positioned on the emitter layer 112 on which the first electrodes 113 and the first electrode current collectors 114 are not positioned, and a second electrode 116 and a second electrode current collector 117 positioned on a second surface (i.e., a back surface opposite the first surface) of the substrate 111.

The solar cell 110 may further include a back surface field (BSF) layer between the second electrode 116 and the substrate 111. The back surface field layer is a region (e.g., a p+-type region) that is more heavily doped than the substrate 111 with impurities of the same conductive type as the substrate 111. The back surface field layer serves as a potential barrier at the back surface of the substrate 111. Thus, because the back surface field layer prevents or reduces a recombination and/or a disappearance of electrons and holes around the back surface of the substrate 111, the efficiency of the solar cell 110 is improved.

The substrate 111 is a semiconductor substrate formed of silicon of first conductive type, for example, p-type, though not required. Silicon used in the substrate 111 may be single crystal silicon, polycrystalline silicon, or amorphous silicon. When the substrate 111 is of a p-type, the substrate 111 contains impurities of a group III element such as boron (B), gallium (Ga), and indium (In).

The surface of the substrate 111 may be textured to form a textured surface corresponding to an uneven surface or having uneven characteristics. When the surface of the substrate 111 is the textured surface, a light reflectance in the light receiving surface of the substrate 111 is reduced. Further, because both a light incident operation and a light reflection operation are performed on the textured surface of the substrate 111, light is confined in the solar cell 110. Hence, absorption of light increases, and the efficiency of the solar cell 110 is improved. In addition, because a reflection loss of light incident on the substrate 111 decreases, an amount of light incident on the substrate 111 further increases.

The emitter layer 112 is a region doped with impurities of a second conductive type (for example, an n-type) opposite the first conductive type of the substrate 111. The emitter layer 112 forms a p-n junction along with the substrate 111. When the emitter layer 112 is of the n-type, the emitter layer 112 may be formed by doping the substrate 111 with impurities of a group V element such as phosphor (P), arsenic (As), and antimony (Sb).

When energy produced by light incident on the substrate 111 is applied to carriers inside the semiconductors, electrons move to the n-type semiconductor and holes move to the p-type semiconductor. Thus, when the substrate 111 is of the p-type and the emitter layer 112 is of the n-type, the holes move to the p-type substrate 111 and the electrons move to the n-type emitter layer 112.

Alternatively, the substrate 111 may be of an n-type and may be formed of semiconductor materials other than silicon. When the substrate 111 is of the n-type, the substrate 111 may contain impurities of a group V element such as phosphorus (P), arsenic (As), and antimony (Sb).

Because the emitter layer 112 forms the p-n junction along with the substrate 111, the emitter layer 112 is of the p-type when the substrate 111 is of the n-type. In this instance, electrons move to the substrate 111 and holes move to the emitter layer 112.

When the emitter layer 112 is of the p-type, the emitter layer 112 may be formed by doping the substrate 111 (or a portion thereof) with impurities of a group III element such as boron (B), gallium (Ga), and indium (In).

The anti-reflection layer 115 on the emitter layer 112 may be formed of silicon nitride (SiNx), silicon dioxide (SiO₂), or titanium dioxide (TiO₂). The anti-reflection layer 115 reduces a reflectance of light incident on the solar cell 110 and increases a selectivity of a predetermined wavelength band, thereby increasing the efficiency of the solar cell 110. The anti-reflection layer 115 may have a thickness of about 70 nm to 80 nm. The anti-reflection layer 115 may be omitted, if desired.

The plurality of first electrodes 113 on the emitter layer 112 may be referred to as finger electrodes. The first electrodes 113 are electrically connected to the emitter layer 112 and are formed in one direction in a state where the adjacent first electrodes 113 are spaced apart from one another. Each of the first electrodes 113 collects carriers (e.g., electrons) moving to the emitter layer 112. The first electrodes 113 are formed of at least one conductive material. The conductive material may be at least one selected from the group consisting of nickel (Ni), copper (Cu), silver (Ag), aluminum (Al), tin (Sn), zinc (Zn), indium (In), titanium (Ti), gold (Au), and a combination thereof. Other conductive materials may be used for the first electrodes 113.

For example, the first electrodes 113 may be formed from an Ag paste. In this instance, the first electrodes 113 may be electrically connected to the emitter layer 112 in a process in which the Ag paste is coated on the anti-reflection layer 115 using a screen printing method and the substrate 111 is fired at a temperature of about 750 °C to 800 °C. The electrical connection between the first electrodes 113 and the emitter layer 112 is performed by etching the anti-reflection layer 115 using an etching component contained in the Ag paste in the firing process and then bringing Ag particles of the Ag paste into contact with the emitter layer 112. The etching component may be lead oxide.

At least two first electrode current collectors 114 are formed on the emitter layer 112 in the direction crossing the first electrodes 113. The first electrode current collectors 114 are electrically and physically connected to the emitter layer 112 and the first electrodes 113. Thus, the first electrode current collectors 114 output carriers (e.g., electrons) transferred from the first electrodes 113 to an external device. The first electrode current collectors 114 are formed of at least one conductive material. The conductive material used for the first electrode current collectors 114 may be at least one selected from the group consisting of Ni, Cu, Ag, Al, Sn, Zn, In, Ti, Au, and a combination thereof. Other conductive materials may be used.

The first electrodes 113 and the first electrode current collectors 114 may be electrically connected to the emitter layer 112 in a process in which the conductive material is coated on the anti-reflection layer 115, patterned, and fired.

As shown in FIG. 5, the surface of the first electrode current collector 114 may be an uneven surface having a plurality of uneven portions. Alternatively, as shown in FIG. 6, the surface of the first electrode current collector 114 may be an even surface. The surface of the first electrode 113 may be an uneven surface having a plurality of uneven portions or an even surface, in the same manner as the first electrode current collector 114.

The second electrode 116 is formed on the second surface of the substrate 111, i.e., the back surface of the substrate 111. The second electrode 116 collects carriers (for example, holes) moving to the substrate 111. The second electrode 116 may be formed on the entire second surface of the substrate 111, the entire second surface of the substrate 111 except edges thereof, or the entire second surface of the substrate 111 except a formation area of the second electrode current collector 117.

The second electrode 116 is formed of at least one conductive material. The conductive material may be at least one selected from the group consisting of Ni, Cu, Ag, Al, Sn, Zn, In, Ti, Au, and a combination thereof. Other conductive materials may be used for the second electrode 116.

The second electrode current collector 117 is positioned on the same surface as the second electrode 116 in the direction crossing the first electrodes 113. Namely, the second electrode current collector 117 is formed in the same direction as the front electrode current collector 114. The second electrode current collector 117 is electrically connected to the second electrode 116. Thus, the second electrode current collectors 117 outputs the carriers (for example, holes) transferred from the second electrode 116 to the external device. The second electrode current collector 117 is formed of at least one conductive material. The conductive material may be at least one selected from the group consisting of Ni, Cu, Ag, Al, Sn, Zn, In, Ti, Au, and a combination thereof. Other conductive materials may be used.

A conductive adhesive film 160 is positioned on the first electrode current collectors 114 in a direction parallel to the first electrode current collectors 114. Further, the conductive adhesive film 160 is positioned on the second electrode current collectors 117.

FIG. 4 shows that one conductive adhesive film 160 is positioned on each of the first and second surfaces of the substrate 111. However, the conductive adhesive films 160 having the same number as the interconnectors 120 may be positioned on each of the first and second surfaces of the substrate 111.

As shown in FIGS. 5 and 6, the conductive adhesive film 160 includes a resin 162 and a plurality of conductive particles 164 dispersed in the resin 162. A material of the resin 162 is not particularly limited as long as it has the adhesive property. It is preferable, but not required, that a thermosetting resin is used for the resin 162 so as to increase an adhesive reliability. The thermosetting resin may use at least one selected among epoxy resin, phenoxy resin, acryl resin, polyimide resin, and polycarbonate resin.

The resin 162 may further contain components other than the thermosetting resin, for example, a curing agent and a curing accelerator. For example, the resin 162 may contain a reforming material such as a silane-based coupling agent, a titanate-based coupling agent, and an aluminate-based coupling agent, so as to improve an adhesive strength between the first electrode current collector 114 and the interconnector 120, and an adhesive strength between the second electrode current collector 117 and the interconnector 120. The resin 162 may contain a dispersing agent such as calcium phosphate and calcium carbonate, so as to improve the dispersibility of the conductive particles 164. The resin 162 may contain a rubber component such as acrylic rubber, silicon rubber, and urethane rubber, so as to control modulus of elasticity.

The resin 162 has a first thickness T1 in an overlap area between the resin 162 and the first electrode current collector 114. A distance between the interconnector 120 and the first electrode current collector 114 is kept at the first thickness T1. The first thickness T1 may be approximately 3 µm to 15 µm. A material of the conductive particles 164 is not particularly limited as long as it has the conductivity.

As shown in FIGS. 5 to 7, the conductive particles 164 may include first conductive particles 164a having a thickness greater than the first thickness T1 and second conductive particles 164b having a thickness less than the first thickness T1.

In other words, the conductive adhesive film 160 may include the plurality of first conductive particles 164a and the plurality of second conductive particles 164b dispersed in the first resin 162. Alternatively, the conductive adhesive film 160 may include only the first conductive particles 164a, or may include only the second conductive particles 164b.

When the conductive adhesive film 160 includes only the first conductive particles 164a, carriers collected by the first electrode current collector 114 may be smoothly transferred to the interconnector 120 because a thickness of each of the first conductive particles 164a is greater than the first thickness T1.

On the other hand, when the conductive adhesive film 160 includes only the second conductive particles 164b, at least two second conductive particles 164b have to vertically overlap each other between the first electrode current collector 114 and the interconnector 120 as shown in FIGS. 6 and 7. Thus, in this instance, carriers collected by the first electrode current collector 114 may be smoothly transferred to the interconnector 120.

Accordingly, it is preferable, but not required, that the thickness of the conductive particles 164 is greater than the first thickness T1 of the resin 162.

In the embodiment of the invention, the thickness of the conductive particles 164 indicates the thickness of the first conductive particles 164a when the conductive adhesive film 160 includes the first conductive particles 164a. When the conductive adhesive film 160 includes only the second conductive particles 164b, the thickness of the conductive particles 164 indicates a sum of the thicknesses of the overlapping second conductive particles 164b.

As shown in FIG. 8, a thickness S1 of the first conductive particle 164a may be approximately 3 µm to 15 µm.

As shown in FIG. 5, the first conductive particles 164a and the second conductive particles 164b may be formed of metal-coated resin particles containing at least one metal selected among copper (Cu), silver (Ag), gold (Au), iron (Fe), nickel (Ni), lead (Pb), zinc (Zn), cobalt (Co), titanium (Ti), and magnesium (Mg) as the main component. Alternatively, as shown in FIG. 6, the first conductive particles 164a and the second conductive particles 164b may be formed of metal particles containing the metal illustrated in FIG. 5 as the main component.

As shown in FIG. 5, when the conductive particles 164 are formed of the metal-coated resin particles, the conductive particles 164 may have a circle shape or an oval shape. Alternatively, as shown in FIG. 6, when the conductive particles 164 are formed of the metal particles, the conductive particles 164 may have a radical shape. In embodiments of the invention, a radical shape refers to a shape that is irregular. For example, the conductive particles 164 having the radical shape may have irregular surfaces, and such irregular surfaces may further have protrusions and/or recessions, or have protrusions or extensions that radially extend outward from a surface, including the irregular surface. In each conductive particle 164 may be a plurality of the protrusions and/or depressions, and heights and depths of the protrusions and recessions on each conductive particle 164 may differ.

In the embodiment of the invention, the conductive particle 164 having the radical shape indicates a particle in which a plurality of projections are non-uniformly formed on the surface of the metal particle having a shape like a sphere.

When the first conductive particles 164a are formed of the metal-coated resin particles having the circle shape or the oval shape, the thickness S 1 of the first conductive particle 164a may be expressed by a diameter of the metal-coated resin particle or a diameter of the metal-coated resin particle in a short axis direction.

When the second conductive particles 164b are formed of the metal-coated resin particles having the circle shape or the oval shape in the same manner as the first conductive particles 164a, the thickness of the second conductive particle 164b may be expressed by a diameter of the metal-coated resin particle or a diameter of the metal-coated resin particle in a short axis direction.

Further, when the first conductive particles 164a are formed of metal particles of radical shape (radical metal particles), as shown in FIG. 8, the thickness S1 of the first conductive particle 164a may be expressed by a shortest diameter on a perpendicular line measured between an upper tangent line contacting an upper most point and a lower tangent line contacting a lower most point of the first conductive particle. In an embodiment of the invention, the upper tangent line and the lower tangent line may be parallel to the substrate. In another embodiment of the invention, the thickness S 1 of the first conductive particle 164a may be expressed by a shortest diameter measured from a sphere like shape formed by a virtual line that connects ends of the plurality of projections formed on the surface of the metal particle to one another.

When the second conductive particles 164b are formed of the radical metal particles in the same manner as the first conductive particles 164a, the thickness of the second conductive particle 164b may be expressed by a shortest diameter on a perpendicular line measured between an upper tangent line contacting an upper most point and a lower tangent line contacting a lower most point of the first conductive particle. In an embodiment of the invention, the upper tangent line and the lower tangent line may be parallel to the substrate. In another embodiment of the invention, the thickness of the second conductive particle 164b may be expressed by a shortest diameter measured from a sphere like shape formed by a virtual line that connects ends of the plurality of projections formed on the surface of the metal particle to one another.

A contact area between the first conductive particles 164a formed of the radical metal particles and the first electrode current collector 114 and/or the interconnector 120 is greater than a contact area between the first conductive particles 164a formed of the metal-coated resin particles and the first electrode current collector 114 and/or the interconnector 120. Hence, a contact resistance may be reduced.

It is preferable, but not required, that a composition amount of the conductive particles 164 dispersed in the resin 162 is about 0.5 % to 20 % based on the total volume of the conductive adhesive film 160 in consideration of the connection reliability after the resin 162 is cured.

When the composition amount of the conductive particles 164 is less than about 0.5 %, electric current may not smoothly flow because a physical contact area between the first electrode current collector 114 and the conductive adhesive film 160 decreases. When the composition amount of the conductive particles 164 is greater than about 20 %, the adhesive strength may be reduced because a relative amount of the resin 162 decreases.

The conductive adhesive film 160 is attached to the first electrode current collector 114 in the direction parallel to the first electrode current collector 114. Further, the conductive adhesive film 160 is attached to the second electrode current collectors 117 in the direction parallel to the second electrode current collector 117.

A tabbing process includes a pre-bonding process for preliminarily bonding the conductive adhesive film 160 to the first electrode current collector 114 of the solar cell and a final-bonding process for bonding the conductive adhesive film 160 to the interconnector 120.

When the tabbing process is performed using the conductive adhesive film 160, a heating temperature and a pressure of the tabbing process are not particularly limited as long as they are within the range capable of securing an electrical connection and maintaining the adhesive strength.

For example, the heating temperature in the pre-bonding process may be set to be equal to or less than about 100 °C, and the heating temperature in the final-bonding process may be set to a curing temperature of the resin 162, for example, about 140 °C to 180 °C.

Further, the pressure in the pre-bonding process may be set to about 1 MPa. The pressure in the final-bonding process may be set to a range capable of sufficiently attaching the first electrode current collector 114, the second electrode current collector 117, and the interconnector 120 to the conductive adhesive film 160, for example, about 2 MPa to 3MPa. In this instance, the pressure in the final-bonding process may be set so that a distance between the first electrode current collector 114 and the interconnector 120 is kept to the first thickness T1 and the first conductive particles having the thickness S1 greater than the first thickness T1 are embedded in the first electrode current collector 114 and/or the interconnector 120.

Time required to heat and apply the pressure in the pre-bonding process may be set within about 5 seconds. Time required to heat and to apply the pressure in the final-bonding process may be set to the extent the first electrode current collector 114, the second electrode current collector 117, the interconnector 120, etc., are not damaged or deformed by heat, for example, about 10 seconds.

The substrate may be warped by the heat applied in the pre-bonding process and the final-bonding process.

**[Table 1]**

| | | Warp amount of substrate (mm) | | | | | Average warp amount (mm) |
|---|---|---|---|---|---|---|---|
| | | Sample 1 | Sample 2 | Sample 3 | Sample 4 | Sample 5 | |
| Substrate thickness in embodiment of invention (µm) | 200 | 0.54 | 0.53 | 0.57 | 0.58 | 0.55 | 0.55 |
| | 180 | 0.72 | 0.65 | 0.81 | 0.74 | 0.83 | 0.75 |
| | 150 | 0.95 | 0.97 | 1.02 | 0.93 | 1.04 | 0.98 |
| | 130 | 1.34 | 1.46 | 1.35 | 1.42 | 1.37 | 1.39 |
| | 100 | 1.63 | 1.65 | 1.72 | 1.55 | 1.64 | 1.63 |
| | 80 | 1.85 | 1.94 | 1.86 | 1.78 | 1.83 | 1.85 |
| Substrate thickness of related art (µm) | 200 | 1.98 | 1.95 | 2.33 | 2.22 | 2.24 | 2.14 |
| | 180 | 3.56 | 3.67 | 2.95 | 2.98 | 3.31 | 3.29 |
| | 150 | 6.57 | 6.98 | 6.02 | 6.45 | 7.32 | 6.67 |
| | 130 | 9.53 | 9.42 | 8.97 | 8.89 | 9.62 | 9.29 |
| | 100 | 12.15 | 12.30 | 13.02 | 13.21 | 12.66 | 12.67 |
| | 80 | 14.55 | 13.86 | 14.63 | 15.77 | 15.39 | 14.84 |

The above Table 1 indicates a warp amount of the substrate based on a thickness T3 (refer to FIG. 4) of the substrate in the tabbing method using the conductive adhesive film according to the embodiment of the invention and a related art tabbing method using hot air. In Table 1, the thickness T3 of the substrate indicates a thickness ranging from the back surface of the substrate to the emitter layer.

As indicated in Table 1, when the thickness of the substrate was about 200 µm, the warp amount of the substrate was equal to or greater than about 2.1 mm in the related art tabbing method for melting flux using the hot air. On the other hand, the warp amount of the substrate was about 0.5 mm in the tabbing method according to the embodiment of the invention.

In the embodiment of the invention, the warp amount of the substrate may be expressed by a difference between heights of a middle portion and a peripheral portion of the back surface of the substrate.

The warp amount of the substrate increased as the thickness of the substrate decreased. For example, the thickness of the substrate was about 80 µm, the warp amount of the substrate was equal to or greater than about 14 mm in the related art tabbing method. On the other hand, the warp amount of the substrate was about 1.8 mm in the tabbing method according to the embodiment of the invention.

According to the result indicated in Table 1, the warp amount of the substrate generated when the thickness of the substrate was about 80 µm in the tabbing method according to the embodiment of the invention was similar to the warp amount of the substrate generated when the thickness of the substrate was about 200 µm in the related art tabbing method.

When the warp amount of the substrate exceeds a predetermined value, for example, about 2.5 mm, a crack is generated in the substrate or bubbles are generated in the solar cell module in a subsequent lamination process. Therefore, it is impossible to use a thin substrate in the related art solar cell module manufactured using the related art tabbing method.

On the other hand, the tabbing method using the conductive adhesive film according to the embodiment of the invention may greatly reduce the warp amount of the substrate, compared with the related art tabbing method. Hence, the solar cell module according to the embodiment of the invention may use the thin substrate.

For example, the substrate 111 having the thickness T3 of about 80 µm to 180 µm may be manufactured through the tabbing method using the conductive adhesive film according to the embodiment of the invention. Because the material cost may be reduced as the thickness of the substrate decreases, the thickness T3 of the substrate 111 according to the embodiment of the invention may be equal to or less than about 180 µm.

A contact surface between the first conductive particles 164a and the interconnector 120 and/or a contact surface between the first conductive particles 164a and the first electrode current collector 114 may be uneven surfaces in a state where the first electrode current collector 114 is attached to the interconnector 120 using the conductive adhesive film 160.

Namely, as shown in FIGS. 5 and 6, some of the first conductive particles 164a are embedded in the interconnector 120. A contact surface between the first conductive particle 164a and the interconnector 120 is substantially the same as the surface shape of a portion of the first conductive particle 164a embedded in the interconnector 120.

When the interconnector 120 includes the conductive metal 122 and the solder 124, some of the first conductive particles 164a may be embedded in the solder 124 of the interconnector 120 or may be embedded in the solder 124 and the conductive metal 122 of the interconnector 120.

In this instance, as shown in FIG. 5, the first conductive particles 164a may be modified into an oval shape because of the pressure applied during the tabbing process and may be embedded in the interconnector 120. Alternatively, the first conductive particles 164a may remain in the circle shape even if the pressure is applied during the tabbing process, and may be embedded in the interconnector 120. The shape of the first conductive particle 164a may vary depending on a difference between hardness and/or strength of the first conductive particles 164a and hardness and/or strength of the interconnector120.

The surface of the first electrode current collector 114 may be the uneven surface having the plurality of uneven portions as shown in FIG. 5, or may be the even surface as shown in FIG. 6. Because the hardness and/or the strength of the first electrode current collector 114 is greater than the hardness and/or the strength of the first conductive particles 164a in this embodiment of the invention, the first conductive particles 164a are not embedded in the first electrode current collector 114.

When the hardness and/or the strength of the first electrode current collector 114 is similar to or less than the hardness and/or the strength of the first conductive particles 164a, some of the first conductive particles 164a may be embedded in the first electrode current collector 114.

The second conductive particles 164b are dispersed in the resin 162. Because the thickness of the second conductive particles 164b is less than the thickness of the first conductive particles 164a, i.e., the first thickness T1 of the resin 162, the second conductive particles 164b in the resin 162 do not contact the first electrode current collector 114 and the interconnector 120 or may contact one of the first electrode current collector 114 and the interconnector 120. Further, as shown in FIG. 6, at least two second conductive particles 164b may be vertically stacked to each other. Stacking of the at least two second conductive particles may be enhanced by the radical shape of the second conductive particles 164b.

According to the above-described connection structure, carriers moving to the first electrode current collector 114 are directly transferred to the interconnector 120 through the first conductive particles 164a. Thus, the transfer efficiency of electric current is improved.

The first conductive particles 164a and the second conductive particles 164b may physically contact the components adjacent to the first and second conductive particles 164a and 164b.

According to the above-described structure, some of carriers moving to the first electrode current collector 114 are directly transferred to the interconnector 120 through the conductive particles 164. The electric current smoothly flows because of an increase in a contact area between the first conductive particles 164a and the interconnector 120.

Further, some of carriers moving to the first electrode current collector 114 jump through the second conductive particles 164b and move to the interconnector 120.

The adjacent first and second conductive particles 164a and 164b may physically contact one another, so that carriers moving to the first electrode current collector 114 are sufficiently transferred to the interconnector 120. Further, at least two first conductive particles 164a may be positioned on the first electrode current collector 114.

The description of FIGS. 5 and 6 illustrating the connection structure between the first electrode current collector 114, the conductive adhesive film 160, and the interconnector 120 may be equally applied to the connection structure between the second electrode current collector 117, the conductive adhesive film 160, and the interconnector 120.

A width of each of the first electrode current collector 114, the conductive adhesive film 160, and the interconnector 120 may vary.

For example, the widths of the first electrode current collector 114, the conductive adhesive film 160, and the interconnector 120 may be substantially equal to one another as shown in FIGS. 5 and 6.

Alternatively, as shown in FIG. 7, the width of the conductive adhesive film 160 may be greater than the width of the interconnector 120 and the width of the first electrode current collector 114. In this instance, the conductive adhesive film 160 may cover one or both sides of the first electrode current collector 114 or at least portions thereof.

Alternatively, or additionally, a portion of the conductive adhesive film 160 may be attached to the surface of the substrate 111, i.e., a portion of the side of the first electrode current collector 114 at a uniform distance from the surface of the anti-reflection layer 115.

The width of the interconnector 120 and the width of the first electrode current collector 114 may be greater than the width of the conductive adhesive film 160.

As described above, the width of each of the first electrode current collector 114, the conductive adhesive film 160, and the interconnector 120 may vary in various manners.

The relation between the widths of the first electrode current collector 114, the conductive adhesive film 160, and the interconnector 120 may be equally applied to the relation between the widths of the second electrode current collector 117, the conductive adhesive film 160, and the interconnector 120, instead of just the first electrode current collector 114.

Even if the interconnector 120 is formed of the lead-free material, the connection between the interconnector 120 and the first electrode current collector 114, and the connection between the interconnector 120 and the second electrode current collector 117 are satisfactorily performed by using the conductive adhesive film 160 having the above-described structure.

The conductive adhesive film 160 may be used to connect the interconnector 120 to the lead wire.

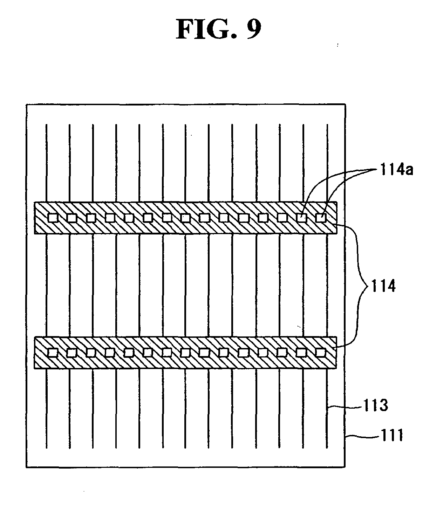

The structure of the first electrode current collector 114 is described below with reference to FIGS. 9 to 11.

FIG. 4 illustrates the first electrode current collector 114 having the line shape.

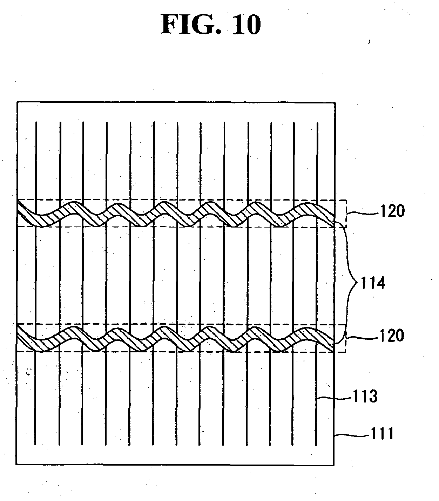

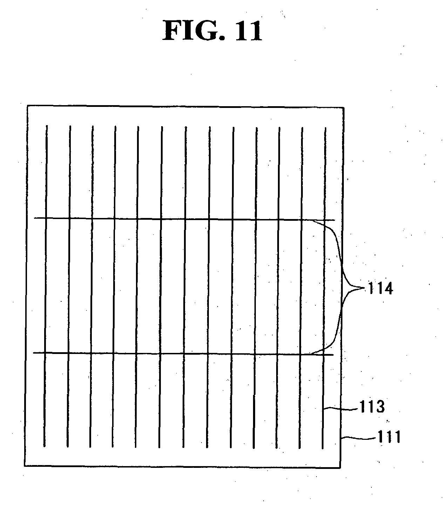

Alternatively, as shown in FIG. 9, the first electrode current collector 114 may have a line shape including a plurality of openings 114a. Alternatively, as shown in FIG. 10, the first electrode current collector 114 may have a meandering pattern. Alternatively, as shown in FIG. 11, the first electrode current collector 114 may have the same width as the first electrode 113. Other shapes and/or patterns are also possible.

The contact reliability of the first electrode current collector 114 having the above-described structure is improved because the resin 162 of the conductive adhesive film 160 is attached to the surface of the substrate 111.

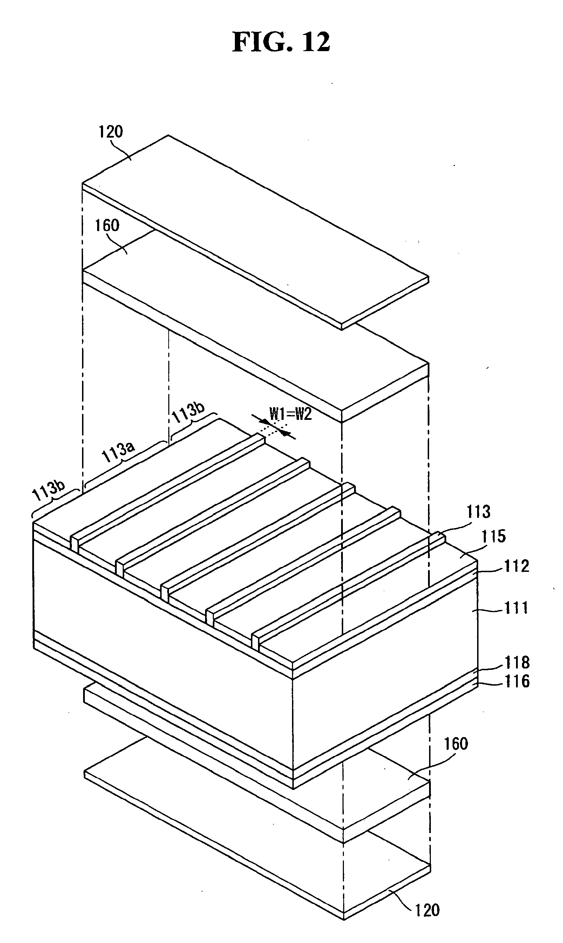

A solar cell panel according to a second embodiment of the invention is described below with reference to FIGS. 12 to 18.

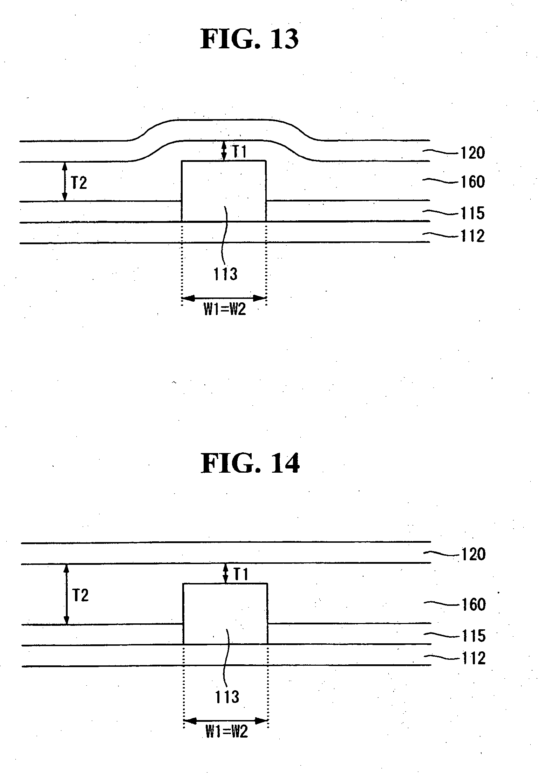

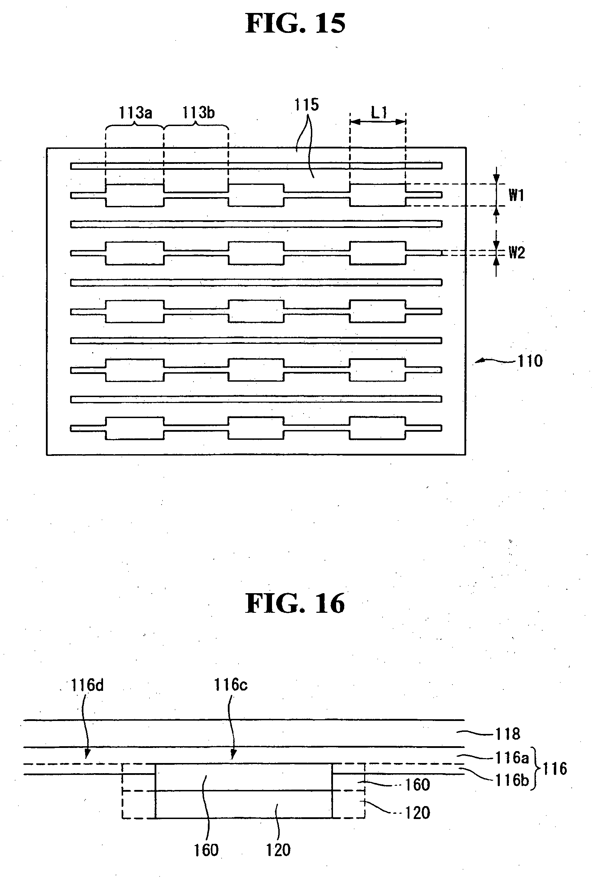

FIG. 12 is an exploded perspective view of a solar cell panel according to a second embodiment of the invention. FIGS. 13 and 14 are cross-sectional views illustrating various assembly configurations of a front surface of a substrate in the solar cell panel shown in FIG. 12. FIG. 15 is a plane view of a front surface of a substrate illustrating various configurations of an electrode part positioned on a first surface of the substrate in the solar cell panel shown in FIG. 12.

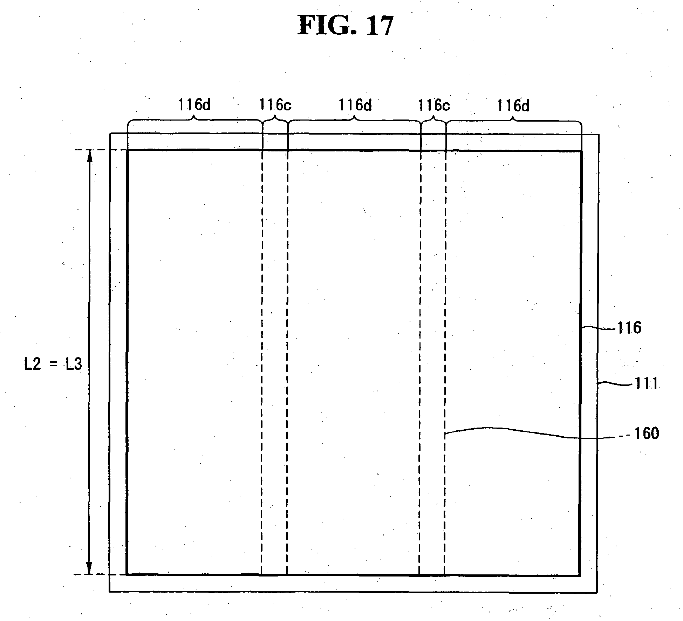

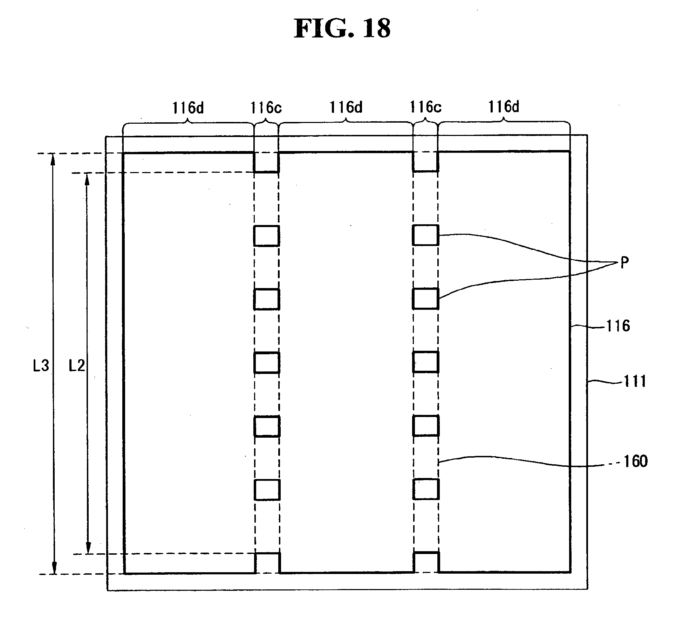

FIG. 16 is a cross-sectional view illustrating various assembly configurations of a back surface of a substrate of the solar cell panel shown in FIG. 12. FIGS. 17 and 18 are plane views of a back surface of a substrate illustrating various configurations of an electrode part positioned on a second surface of the substrate in the solar cell panel shown in FIG. 12.

Each of the solar cells included in the solar cell panel according to the first embodiment of the invention includes both the first electrode current collector 114 and the second electrode current collector 117. On the other hand, each of solar cells included in the solar cell panel according to the second embodiment of the invention does not include both the first electrode current collector and the second electrode current collector.

Namely, the solar cell according to the second embodiment of the invention has a non-bus bar structure that does not include the current collector. Because the solar cell of the non-bus bar structure may reduce an amount of metal material, for example, silver (Ag) used to form the current collector, the manufacturing cost may be reduced.

However, a carrier transfer efficiency of the solar cell not including the current collector may be less than a carrier transfer efficiency of the solar cell including the current collector. Nevertheless, the solar cell panel according to the second embodiment of the invention may obtain the efficiency of the same level as the related art solar cell, in which the tabbing process is performed on the current collector and the interconnector using the flux, by using a conductive adhesive film.

A solar cell 110 according to the second embodiment of the invention includes a substrate 111, an emitter layer 112 positioned at a first surface, i.e., a front surface of the substrate 111, a plurality of first electrodes 113 positioned on the emitter layer 112, an anti-reflection layer 115 positioned on the emitter layer 112 on which the first electrodes 113 are not positioned, a second electrode 116 positioned on a second surface, i.e., a back surface opposite the first surface of the substrate 111, and a back surface field (BSF) layer 118 positioned between the second electrode 116 and the substrate 111.

A plurality of conductive adhesive films 160 are positioned on the emitter layer 112 in a direction crossing the plurality of first electrodes 113. Further, the plurality of conductive adhesive films 160 are positioned on the second electrode 116 in the direction crossing the plurality of first electrodes 113.

FIG. 12 shows that one conductive adhesive film 160 is positioned on each of the front surface and the back surface of the substrate 111. However, the same number of the conductive adhesive films 160 as the number of the interconnectors 120 may be positioned on each of the front surface and the back surface of the substrate 111. For example, three or four conductive adhesive films 160 may be used in each of the front surface and the back surface of the substrate 111.

The conductive adhesive film 160 on the front surface of the substrate 111 is attached to a portion of each first electrode 113 in the direction crossing the plurality of first electrodes 113. Thus, a portion of the conductive adhesive film 160 directly contacts the portion of each first electrode 113, and a remaining portion of the conductive adhesive film 160 directly contacts the anti-reflection layer 115.

As a result, the conductive adhesive film 160 covers an upper surface of each first electrode 113 and both sides of each first electrode 113 in a width direction in an overlap area between the conductive adhesive film 160 and the first electrodes 113. Further, the conductive adhesive film 160 covers a space between the first electrodes 113.

In embodiments of the invention, each first electrode 113 may include a first portion 113a attached to the conductive adhesive film 160 and a second portion 113b not attached to the conductive adhesive film 160.

A portion of the interconnector 120 is attached to a front surface of the conductive adhesive film 160 that is attached to the first portion 113a of the first electrode 113 in the same direction as a formation direction of the conductive adhesive film 160. A remaining portion of the interconnector 120 not attached to the conductive adhesive film 160 that is attached to the first portion 113a is attached to a conductive adhesive film 160 attached to a second electrode 116 of an adjacent solar cell 110.

In the second embodiment of the invention, first, conductive particles 164a of the conductive adhesive film 160 may be embedded in the first electrodes 113 and/or the interconnector 120 in a state where the first electrodes 113 are attached to the interconnector 120 by the conductive adhesive film 160, in the same manner as the first embodiment.

The remaining portion of the conductive adhesive film 160 that is not attached to the first portions 113a of the first electrodes 113 directly contacts the anti-reflection layer 115 on the emitter layer 112.

The conductive adhesive film 160 may have a thickness greater than a protruding thickness of the first electrode 113, so that the conductive adhesive film 160 and the interconnector 120 are sufficiently attached to each other.

Namely, a resin 162 has a first thickness T1 in the overlap area between the conductive adhesive film 160 and the first electrodes 113, but may have a second thickness T2 greater than the first thickness T1 in a non-overlap area between the conductive adhesive film 160 and the first electrodes 113. In this instance, as shown in FIG. 13, the front surface of the conductive adhesive film 160 has a height difference (or a bump) because of the first electrodes 113. Alternatively, as shown in FIG. 14, the front surface of the conductive adhesive film 160 forms an even surface, and there is not a height difference (or a bump) in the conductive adjacent film 160.

When the front surface of the conductive adhesive film 160 is the even surface, the interconnector 120 and the conductive adhesive film 160 are satisfactorily attached to each other because the interconnector 120 does not have a height difference.

In the solar cell shown in FIGS. 12 to 14, a width W1 of the first portion 113a of the first electrode 113 is substantially equal to a width W2 of the second portion 113b of the first electrode 113. Alternatively, the width W of the first portion 113a may be different from the width of the second portion.

As shown in FIG. 15, the width W1 of the first portion 113a of the first electrode 113 may be greater than the width W2 of the second portion 113b of the first electrode 113. When the width W 1 of the first portion 113a is greater than the width W2 of the second portion 113b, an adhesive strength between the conductive adhesive film 160 and the first electrode 113 is improved, and a contact resistance between the conductive adhesive film 160 and the first electrode 113 decreases. Hence, a reduction in an output of the solar cell panel may be prevented or reduced. The first portion 113a of the first electrode 113 may partially serve as a current collector.

Only the first electrodes 113 positioned on predetermined rows of a plurality of first electrode rows may be ones that include the first portions 113a having the width W1 greater than the width W2 of the second portion 113b. The first electrodes 113 positioned on remaining rows may include the first portions 113a having the same width as the second portion 113b. For example, as shown in FIG. 15, the first electrodes 113 positioned on even-numbered rows may include the first portions 113a having the width W1 greater than the width W2 of the second portion 113b, and the first electrodes 113 positioned on odd-numbered rows may include the first portions 113a having the same width as the second portion 113b.

The first portions 113a are formed in a vertically symmetric manner based on the first electrode 113 and have a predetermined length L1 in a longitudinal direction of the first electrode 113. The predetermined length L1 of the first portion 113a may be properly selected based on the width of the conductive adhesive film 160, so as to improve or maximize the adhesive strength between the conductive adhesive film 160 and the first electrodes 113, and to reduce the contact resistance between the conductive adhesive film 160 and the first electrodes 113.

When the width of the conductive adhesive film 160 is less than about 1 mm, the contact resistance increases. When the width of the conductive adhesive film 160 is greater than about 20 mm, the light receiving area decreases. Thus, it is preferable, but not required, that the width of the conductive adhesive film 160 is about 1 mm to 20 mm.

The first electrodes 113 positioned on the odd-numbered rows or all of the rows may include the first portions 113a having the width W1 greater than the width W2 of the second portion 113b.

The adjacent first portions 113a may protrude opposite each other, or may protrude to face each other. The adjacent first portions 113a may all protrude in the same direction, such as all towards the upper portion of FIG. 15.

In the second embodiment, the second electrode 116 is formed of aluminum (Al). Thus, the second electrode 116 may be formed by coating an aluminum paste on the entire back surface of the substrate 111 and firing the Al paste.

The Al paste used includes an aluminum powder and bismuth oxide, each of which has a medium diameter D50 equal to or less than about 10 µm in a particle distribution based on a laser diffraction method, as the main component. The A1 paste may include a bismuth-based glass frit and an organic vehicle, each of which has a glass softening temperature equal to or less than about 580 °C.

The aluminum powder refers to an aggregate of particles containing aluminum as the main component and may contain a small amount of impurities other than aluminum.

The medium diameter D50 refers to a diameter when a cumulative volume is about 50 % in a particle distribution of the corresponding powder. The medium diameter D50 may be easily measured using various particle distribution measuring devices based on the laser diffraction method.

It is preferable, but not required, that particles constituting the aluminum powder have a sphere shape. However, other shapes such as a flake shape and a non-uniform shape may be used for the particles of the aluminum powder.

It is preferable, but not required, that an amount of aluminum powder is about 65 % to 85 % based on the total amount of aluminum paste, and an amount of bismuth oxide in the bismuth-based glass frit is equal to or more than about 40 % based on the total amount of bismuth-based glass frit.

Examples of the bismuth-based glass frit include a glass frit containing bismuth oxide, boron oxide (B₂O₃), and zinc oxide (ZnO) as the main component, a glass frit containing bismuth oxide, boron oxide (B₂O₃), and silicon oxide as the main component, and a glass frit containing bismuth oxide, silicon oxide, and lead oxide as the main component. In addition, the bismuth-based glass frit may further contain barium oxide (BaO) and silicon dioxide (SiO₂).

An amount of the bismuth-based glass frit having the above-described configuration may be about 1 % to 10 % based on the total amount of the aluminum paste.

The organic vehicle is not particularly limited as long as it can sufficiently disperse the aluminum powder and the bismuth-based glass frit. The organic vehicle may be at least one kind of organic solvent having a high boiling point, such as ethylene glycol, diethylene glycol derivative (glycol ether-based derivative), toluene, and xylene.

An amount of organic vehicle may be about 10 % to 30 % based on the total amount of the aluminum paste.

The second electrode 116 may be manufactured by coating the aluminum paste manufactured thus on the entire back surface of the substrate 111 (in this instance, edges of the back surface of the substrate 111 may be excluded), drying the coated aluminum paste at a proper temperature (for example, a room temperature or about 100 °C), and heating (or firing) the dried aluminum paste using a firing furnace under the proper heating conditions (for example, at a temperature of about 700 °C to 800 °C). The back surface field layer 118 is formed simultaneously with the firing of the aluminum paste.

As shown in FIG. 16, when the second electrode 116 is manufactured using the aluminum paste, a high density aluminum layer 116a is formed on the surface of the substrate 111 and a low density aluminum layer 116b is formed on the surface of the high density aluminum layer 116a. Further, an aluminum oxide layer is formed on the surface of the low density aluminum layer 116b. Alternatively, impurities exist in the surface of the low density aluminum layer 116b.

When the aluminum oxide layer or the impurities exist at the surface of the second electrode 116, an adhesive strength between the conductive adhesive film 160 and the second electrode 116 may be reduced. Thus, before the conductive adhesive film 160 is attached to the second electrode 116, the surface processing of the second electrode 116 may be performed.

The surface processing of the second electrode 116 may be performed through a cleansing process using a gas (for example, air or an inert gas such as nitrogen gas) or pure water or a grinding process using a roller.

When the surface processing of the second electrode 116 is performed, the low density aluminum layer 116b may be removed along with the aluminum oxide layer or the impurities existing in the surface of the second electrode 116.

The conductive adhesive film 160 is attached to the second electrode 116 having the above-described configuration. The second electrode 116 includes a first portion 116c attached to the conductive adhesive film 160 and a second portion 116d adjacent to the first portion 116c. Thus, the conductive adhesive film 160 directly contacts the first portion 116c of the second electrode 116.

Because the second electrode 116 is formed using the aluminum paste, the first portion 116c and the second portion 116d contain the same material.

A portion of the interconnector 120 is attached to a back surface of the conductive adhesive film 160 attached to the first portion 116c of the second electrode 116 in the same direction as a formation direction of the conductive adhesive film 160. A remaining portion of the interconnector 120 not attached to the conductive adhesive film 160 attached to the first portion 113c is electrically connected to the first electrodes 113 of an adjacent solar cell 110.

A portion of the first conductive particles 164a may be embedded in the second electrode 116 and/or the interconnector 120 in a state where the second electrode 116 is attached to the interconnector 120 by the conductive adhesive film 160, in the same manner as the first embodiment.

The surface processing of the second electrode 116 for removing the aluminum oxide layer and/or the impurities existing in the surface of the second electrode 116 may be performed only on the first portion 116c of the second electrode 116 attached to the conductive adhesive film 160. In this instance, the low density aluminum layer 116b on the surface of the high density aluminum layer 116a is removed along with the aluminum oxide layer and/or the impurities.

Thus, as shown in FIG. 16, the first portion 116c of the second electrode 116 may be formed of only the high density aluminum layer 116a, and the second portion 116d of the second electrode 116 may be formed of the high density aluminum layer 116a, the low density aluminum layer 116b, and the aluminum oxide layer. Therefore, a thickness of the first portion 116c is less than a thickness of the second portion 116d.

When the thickness of the first portion 116c is less than the thickness of the second portion 116d, the width of the conductive adhesive film 160 may be equal to or less than a width of the first portion 116c as indicated by the solid line shown in FIG. 16. In the structure shown in FIG. 16, the conductive adhesive film 160 directly contacts the first portion 116c, but does not directly contact the second portion 116d. In this instance, the width of the conductive adhesive film 160 may be equal to or greater than the width of the interconnector 120. Alternatively, the width of the conductive adhesive film 160 may be less than the width of the interconnector 120.

Further, the width of the conductive adhesive film 160 may be greater than the width of the first portion 116c as indicated by the dotted line shown in FIG. 16. In this instance, the width of the conductive adhesive film 160 may be equal to or greater than the width of the interconnector 120. Alternatively, the width of the conductive adhesive film 160 may be less than the width of the interconnector 120.

Even if the second electrode 116 does not include the low density aluminum layer 116b, the aluminum oxide layer existing in the surface of the second electrode 116 may be removed. Therefore, a slight thickness difference between the first and second portions 116c and 116d may be generated.

Further, when the surface processing is performed on the entire surface of the second electrode 116, both the first and second portions 116c and 116d are formed of only the high density aluminum layer 116a. Therefore, the first and second portions 116c and 116d have substantially the same thickness. In this instance, the width of the conductive adhesive film 160 is substantially equal to the width of the first portion 116c.

As shown in FIG. 17, the second electrode 116 may be formed on the entire back surface of the substrate 111 except the edges of the substrate 111.

In this instance, a length of the conductive adhesive film 160 may be equal to, slightly shorter than, or slightly longer than a length L2 of the first portion 116c and a length L3 of the second portion 116d.

As shown in FIG. 18, the length L2 of the first portion 116c may be shorter than the length L3 of the second portion 116d.

In this instance, because the length of the conductive adhesive film 160 is longer than the length L2 of the first portion 116c, the adhesive strength may increase by bringing at least one end of the conductive adhesive film 160 into direct contact with the substrate 111 outside the first portion 116c.

Further, the length of the conductive adhesive film 160 may be substantially equal to the length L3 of the second portion 116d. Alternatively, the length of the conductive adhesive film 160 may be substantially equal to or shorter than the length L2 of the first portion 116c.

As shown in FIG. 18, hole patterns P exposing the substrate 111 may be formed in a portion of the first portion 116c of the second electrode 116. In the structure shown in FIG. 18, because the conductive adhesive film 160 directly contacts the substrate 111 in the hole patterns P, the adhesive strength of the conductive adhesive film 160 increases.

FIG. 18 shows the hole patterns P positioned parallel to one another in a row direction, i.e., in a transverse direction in FIG. 18. Alternatively, the hole patterns P may not be parallel to one another in the row direction and may be non-uniformly positioned.

In the structure shown in FIG. 18, carriers moving to the second electrode 116 are transferred to the interconnector through the first and second conductive particles of the conductive adhesive film 160. Thus, because the second electrode current collector for transferring the carriers moving to the second electrode 116 to the interconnector is not necessary, the process and the cost required to form the second electrode current collector may be reduced.

The conductive adhesive film 160 may be positioned in a state of directly contacting the back surface of the substrate. In this instance, the second electrode 116 may include a plurality of electrode parts, which are spaced apart from one another at a predetermined gap. The gap between the electrode parts may expose the back surface of the substrate, so that the conductive adhesive film 160 can directly contact the back surface of the substrate.

The plurality of electrode parts may be manufactured by coating a conductive paste containing a conductive material on the entire back surface of the substrate, drying and firing the conductive paste, and removing the conductive paste existing at a location to form the conductive adhesive film. The entire back surface of the substrate may include the exclusion of the edges of the back surface of the substrate.

According to the above-described method, when the conductive paste is fired, impurities are injected into the substrate. Hence, the back surface field layer is formed at the entire back surface of the substrate.

As above, when the second electrode includes the plurality of electrode parts, the adhesive strength using the plurality of electrode parts is better than the adhesive strength using the conductive adhesive film. Because it is difficult to attach the conductive adhesive film to the back surface of the second electrode by the oxide layer formed on the surface of the second electrode.

Thus, as described above, the plurality of electrode parts are positioned to be spaced apart from one another at the uniform gap, and the conductive adhesive film is attached to the back surface of the substrate exposed through the gap. Hence, the adhesive strength better than the adhesive strength using the conductive adhesive film can be obtained.

A thickness of the conductive adhesive film may be substantially equal to or slightly greater than a thickness of each of the electrode parts of the second electrode. Alternatively, the thickness of the conductive adhesive film may be less than the thickness of each of the electrode parts of the second electrode. The width of the interconnector may be substantially equal to or greater than a width of the gap.

The second electrode 116 including the electrode parts may be manufactured using methods other than the above-described method.

For example, the second electrode 116 including the electrode parts may be manufactured using a mask, in which the gap is filled, without performing a separate process for forming the gap.

However, in this instance, the back surface field layer 118 formed during the process for firing the conductive paste may have the same pattern as the second electrode 116. Namely, the back surface field layer 118 may be formed only in the formation area of the electrode parts, and the back surface field layer 118 may not be formed in the substrate area in which the gap is formed.

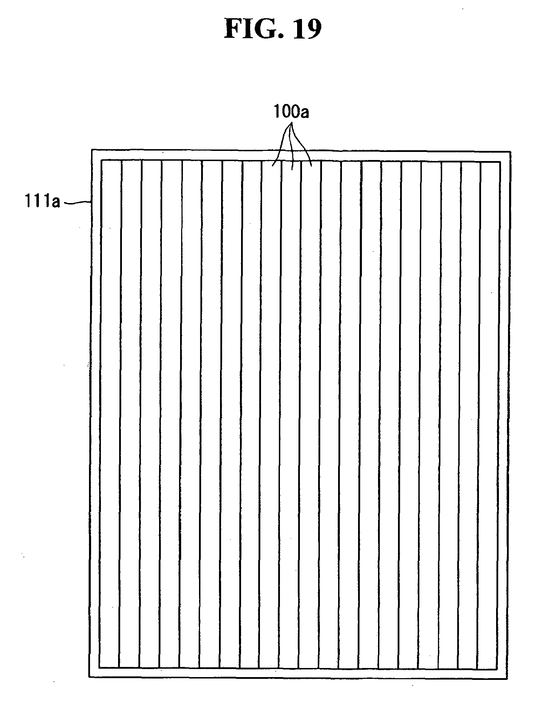

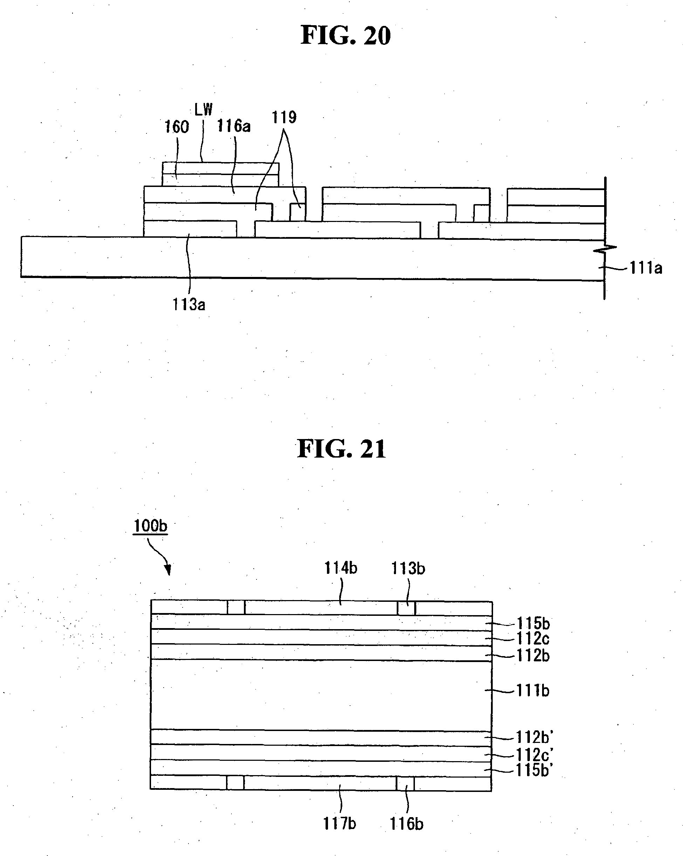

FIG. 19 is a plane view of a solar cell panel according to a third embodiment of the invention. FIG. 20 is a partial cross-sectional view of the solar cell panel shown in FIG. 19.

A solar cell used in the third embodiment of the invention is a thin film solar cell, and electrodes positioned at the outermost side of the thin film solar cell are attached to lead wires using a conductive adhesive film.

The thin film solar cell panel according to the third embodiment of the invention includes a substrate 111a and a plurality of thin film solar cells 100a positioned on the substrate 111a.

The substrate 111a includes an electricity generation area and an edge area positioned at an edge of the electricity generation area. The plurality of thin film solar cells 100a are positioned in the electricity generation area.

Each of the plurality of thin film solar cells 100a includes a first electrode 113a, a photoelectric conversion unit 119, and a second electrode 116a, which are sequentially stacked on the substrate 111a.

The first electrode 113a may be formed of metal oxide, for example, at least one material selected among tin dioxide (SnO₂), zinc oxide (ZnO), and indium tin oxide (ITO). Alternatively, the first electrode 113a may be formed of a mixture obtained by mixing at least one kind of impurities with the metal oxide.

The photoelectric conversion unit 119 positioned on the first electrode 113a converts light incident on a light incident surface of the substrate 111a into electric current. The photoelectric conversion unit 119 may have a single junction structure, a double junction structure, or a triple junction structure. In embodiments of the invention, the photoelectric conversion unit 119 may have additional junction structures.

When the photoelectric conversion unit 119 has the double junction structure or the triple junction structure, a reflection layer may be formed between the photoelectric conversion units 119. Other structures may be used for the photoelectric conversion unit 119.

The second electrode 116a positioned on the photoelectric conversion unit 119 may be formed of one metal selected among gold (Au), silver (Ag), and aluminum (Al). The second electrode 116a is electrically connected to a first electrode 113a of an adjacent thin film solar cell 100a. For example, a second electrode 116a of an outermost thin film solar cell 100a adjacent to the edge area is electrically connected to a first electrode 113a of a thin film solar cell 100a adjacent to the outermost thin film solar cell 100a. Thus, the plurality of thin film solar cells 100a are electrically connected in series to one another.

A lead wire LW is positioned on a thin film solar cell 100a positioned at a location adjacent to the edge area. A conductive adhesive film 160 is positioned between the lead wire LW and the second electrode 116a.

The thin film solar cell module including the plurality of thin film solar cells having the above-described structure is covered by a protective layer, for example, ethylene vinyl acetate (EVA) for covering the thin film solar cells. The protective layer partially overlaps a frame in the edge area of the substrate 111a.

As above, the frame and the substrate 111a may overlap each other by the width of the edge area. Thus, the frame shields light incident on the light incident surface of the substrate 111a by an overlapped width therebetween.

The third embodiment of the invention described a general thin film solar cell module. Further, the thin film solar cell according to the third embodiment of the invention may be a thin film solar cell containing four or more elements, for example, a CIGS (cooper/indium/gallium/sulfur) thin film solar cell. The conductive adhesive film 160 according to the third embodiment of the invention may be used in the thin film solar cell having the various structures.

FIG. 21 is a side view of a HIT (Heterojunction with Intrinsic Thin layer) solar cell used in a solar cell panel according to a fourth embodiment of the invention.

A HIT solar cell 100b according to the fourth embodiment of the invention includes a semiconductor substrate 111b of a first conductive type, an intrinsic semiconductor layer 112b positioned at a first surface of the semiconductor substrate 111b, a hydrogenated amorphous silicon (a-Si) layer 112c of a second conductive type positioned on the intrinsic semiconductor layer 112b, a transparent conductive oxide (TCO) layer 115b positioned on the hydrogenated a-Si layer 112c, a first electrode 113b positioned on the TCO layer 115b, an intrinsic semiconductor layer 112b' positioned at a second surface of the semiconductor substrate 111b, an amorphous silicon layer 112c' of the first conductive type positioned on the intrinsic semiconductor layer 112b', a TCO layer 115b' positioned on the amorphous silicon layer 112c', and a second electrode 116b positioned on the TCO layer 115b'.

The HIT solar cell 100b further includes a first electrode current collector 114b crossing the first electrode 113b and a second electrode current collector 117b crossing the second electrode 116b.

The first electrode current collector 114b and the second electrode current collector 117b may be manufactured to be wider than the first electrode 113b and the second electrode 116b, respectively (refer to FIG. 4). Alternatively, the first electrode current collector 114b and the second electrode current collector 117b may be manufactured, so that their widths are substantially equal to the first electrode 113b and the second electrode 116b, respectively (refer to FIG. 11).

Further, the first electrode current collector 114b and the second electrode current collector 117b may be formed in a state where they are not physically connected to the first electrode 113b and the second electrode 116b, respectively. Because the first electrode 113b and the first electrode current collector 114b are electrically connected to the TCO layer 115b and the second electrode 116b and the second electrode 116b are electrically connected to the TCO layer 115b', carriers may be collected by the first and second electrode current collectors 114b and 117b even if the first and second electrode current collectors 114b and117b are not physically connected to the first and second electrodes 113b and 116b, respectively. For this reason, each of the first and second electrode current collectors 114b and 117b may include a plurality of current collector electrodes positioned in an oblique direction of the corresponding electrode.

## Claims

1. A solar cell module comprising:
a plurality of solar cells (110), each of the plurality of solar cells (110) including a substrate (111) and an electrode part positioned on the substrate (111);
an interconnector (120) configured to electrically connect adjacent solar cells (110) of the plurality of solar cells to each other; and
a conductive adhesive film (160) positioned between the electrode part of each solar cell (110) and the interconnector (120), the conductive adhesive film (160) being configured to electrically connect the electrode part of each solar cell (110) to the interconnector (120), the conductive adhesive film (160) including a resin (162) having a first thickness (T1) in an overlap area of the conductive adhesive film (160), the electrode part and the interconnector (120), and having conductive particles (164), which are dispersed in the resin (162),
wherein the conductive particles (164) are formed of metal particles having a radical shape, wherein the conductive particle (164) having the radical shape indicates a particle in which a plurality of projections are non-uniformly formed on the surface of the metal particle having a shape like a sphere,
wherein the conductive particles (164) include first conductive particles (164a) having thicknesses greater than the first thickness (T1), **characterized in that**
the conductive particles (164) further include second conductive particles (164b) having thicknesses less than the first thickness (T1),
wherein the first conductive particles (164a) are embedded in the interconnector (120) and the electrode part, respectively, and
wherein at least two second conductive particles (164b) of the second particles are overlapping in the overlap area, and a sum of the thicknesses of the overlapping second conductive particles (164b) is greater than the first thickness (T1).

2. The solar cell module of claim 1, **characterized in that** a distance between the interconnector (120) and the electrode part is kept at the first thickness.

3. The solar cell module of claim 1, **characterized in that** the substrate (111) has a thickness of about 80 µm to 180 µm.

4. The solar cell module of claim 1, **characterized in that** the conductive particles are formed of metal particles containing at least one metal selected among copper (Cu), silver (Ag), gold (Au), iron (Fe), nickel (Ni), lead (Pb), zinc (Zn), cobalt (Co), titanium (Ti), and magnesium (Mg) as the main component.

5. The solar cell module of claim 1, **characterized in that** the interconnector (120) includes a conductive metal (122) formed of a lead-free material containing lead (Pb) equal to or less than about 1,000 ppm or said conductive metal (122) and a solder (124) formed of a Pb-containing material coated on a surface of the conductive metal (122).

6. The solar cell module of claim 1, **characterized in that** a surface of the electrode part is an even surface or an uneven surface having a plurality of uneven portions.

7. The solar cell module of claim 1, **characterized in that** the electrode part (114) includes a plurality of first electrodes (113) positioned on a first surface of the substrate (111), and
wherein the conductive adhesive film (160) is positioned in a direction crossing the plurality of first electrodes (113) and covers a portion of an upper surface and both sides of each of the plurality of first electrodes (113) and a space between the plurality of first electrodes (113).

8. The solar cell module of claim 7, **characterized in that** the resin (162) has a second thickness greater than the first thickness in a non-overlap area between the conductive adhesive film (160) and the plurality of first electrodes (113), and the thickness of the first conductive particles (164a) is less than the second thickness.

9. The solar cell module of claim 1, **characterized in that** the electrode part includes a plurality of first electrodes (113) positioned on a first surface of the substrate (111) and a plurality of first electrode current collectors (114) crossing the plurality of first electrodes (113), and
wherein the conductive adhesive film (160) is positioned on the plurality of first electrode current collectors (114) in a direction parallel to the plurality of first electrode current collectors (114).

10. The solar cell module of claim 7, **characterized in that** the electrode part includes a second electrode (116) positioned on a second surface of the substrate (111), and
wherein the conductive adhesive film (160) directly contacts the second electrode (116).

11. The solar cell module of claim 9, **characterized in that** the electrode part includes a second electrode (116) positioned on a second surface of the substrate (111) and a second electrode current collector (117) electrically connected to the second electrode (116), and
wherein the conductive adhesive film (160) directly contacts the second electrode current collector (117).

12. The solar cell module of claim 1, **characterized in that** the second conductive particles (164b) which are not overlapping in the overlap area are not embedded in the interconnector (120) and the electrode part.

## Patentansprüche

1. Solarzellenmodul, das aufweist:
eine Vielzahl von Solarzellen (110), wobei jede der Vielzahl von Solarzellen (110) ein Substrat (111) und einen auf dem Substrat (111) gelegenen Elektrodenabschnitt aufweist;
einen Verbinder (120), der dazu ausgebildet ist, benachbarte Solarzellen (110) der Vielzahl von Solarzellen miteinander zu verbinden; und
einen leitenden Klebefilm (160), der zwischen dem Elektrodenabschnitt jeder Solarzelle (110) und dem Verbinder (129) gelegen ist, wobei der leitende Klebefilm (160) dazu ausgebildet ist, den Elektrodenbereich jeder Solarzelle (110) mit dem Verbinder (120) elektrisch zu verbinden, wobei der leitende Klebefilm (160) ein Harz (162) umfasst, das eine erste Dicke (T1) in einem Überlappbereich des leitenden Klebefilms (160), des Elektrodenabschnitts und des Verbinders (120) hat, und das leitende Teilchen (164) hat, die in dem Harz (162) verteilt sind,
wobei die leitenden Teilchen (164) aus Metallteilchen gebildet sind, die eine radikale Form haben, wobei das leitende Teilchen (164), das die radikale Form hat, ein Teilchen angibt, bei dem eine Vielzahl von Vorsprüngen ungleichmäßig auf der Oberfläche des Metallteilchens mit kugelähnlicher Form gebildet sind,
wobei die leitenden Teilchen (164) erste leitende Teilchen (164a) umfassen, die eine größere Dicke als die erste Dicke (T1) haben, **dadurch gekennzeichnet, dass**
die leitenden Teilchen (164) weiterhin zweite leitende Teilchen (164) enthalten, die jeweils eine kleinere Dicke als die erste Dicke (T1) haben,
wobei die ersten leitenden Teilchen (164b) jeweils in den Verbinder (120) und den Elektrodenabschnitt eingebettet sind, und
wobei wenigstens zwei zweite leitende Teilchen (164b) der zweiten Teilchen einander in dem Überlappbereich überlappen, und eine Summe der Dicken der überlappenden zweiten leitenden Teilchen (164b) größer als die erste Dicke (T1) ist.

2. Solarzellenmodul nach Anspruch 1, **dadurch gekennzeichnet, dass** ein Abstand zwischen dem Verbinder (120) und dem Elektrodenabschnitt bei der ersten Dicke belassen wird.

3. Solarzellenmodul nach Anspruch 1, **dadurch gekennzeichnet, dass** das Substrat (111) eine Dicke von ungefähr 80 µm bis 180 µm hat.

4. Solarzellenmodul nach Anspruch 1, **dadurch gekennzeichnet, dass** die leitenden Teilchen aus Metallteilchen gebildet sind, die wenigstens eines der Metalle ausgewählt aus Kupfer (Cu), Silber (Ag), Gold (Au), Eisen (Fe), Nickel (Ni), Blei (Pb), Zink (Zn), Kobalt (Co), Titan (Ti), und Magnesium (Mg) als Hauptbestandteil enthalten.

5. Solarzellenmodul nach Anspruch 1, **dadurch gekennzeichnet, dass** der Verbinder (120) ein leitendes Metall (122) enthält, das aus einem bleifreien Material gebildet ist, das Blei (Pb) gleich oder weniger als 1,000 ppm enthält, oder dieses leitende Metall (122) und ein Lot (124) enthält, das aus einem Pb-enthaltenen Material gebildet ist, das auf einer Oberfläche des leitenden Metalls (122) beschichtet aufgebracht ist.

6. Solarzellenmodul nach Anspruch 1, **dadurch gekennzeichnet, dass** eine Oberfläche des Elektrodenabschnitts eine ebene Oberfläche ist, oder eine unebene Oberfläche, die eine Vielzahl von unebenen Bereichen hat.

7. Solarzellenmodul nach Anspruch 1, **dadurch gekennzeichnet, dass** der Elektrodenabschnitt (114) eine Vielzahl von ersten Elektroden (113) beinhaltet, die auf einer ersten Oberfläche des Substrats (111) gelegen sind, und
wobei der leitende Klebefilm (160) in einer Richtung gelegen ist, die die Vielzahl von ersten Elektroden (113) kreuzt, und er einen Bereich einer oberen Oberfläche und beider Seiten jeder der Vielzahl von ersten Elektroden (113) und einen Raum zwischen der Vielzahl von ersten Elektroden (113) bedeckt.

8. Solarzellenmodul nach Anspruch 7, **dadurch gekennzeichnet, dass** das Harz (162) in einem nicht-überlappenden Bereich zwischen dem leitenden Klebefilm (160) und der Vielzahl von ersten Elektroden (113) eine zweite Dicke hat, die größer als die erste Dicke ist, und die Dicke der ersten leitenden Teilchen (164a) kleiner als die zweite Dicke ist.

9. Solarzellenmodul nach Anspruch 1, **dadurch gekennzeichnet, dass** der Elektrodenabschnitt eine Vielzahl von ersten Elektroden (113), die auf einer ersten Oberfläche des Substrats (111) gelegen sind, und eine Vielzahl von Stromabnehmern (114) der ersten Elektroden beinhaltet, die die Vielzahl von ersten Elektroden (113) kreuzen, und
wobei der leitende Klebefilm (160) auf der Vielzahl von Stromabnehmern (114) der ersten Elektroden in einer Richtung parallel zu der Vielzahl von Stromabnehmern (114) der ersten Elektroden gelegen ist.

10. Solarzellenmodul nach Anspruch 7, **dadurch gekennzeichnet, dass** der Elektrodenabschnitt eine zweite Elektrode (116) beinhaltet, die auf einer zweiten Oberfläche des Substrats (111) gelegen ist,
wobei der leitende Klebefilm (160) unmittelbar die zweite Elektrode (116) berührt.

11. Solarzellenmodul nach Anspruch 9, **dadurch gekennzeichnet, dass** der Elektrodenabschnitt eine zweite Elektrode (116) beinhaltet, die auf einer zweiten Oberfläche des Substrats (111) gelegen ist, und einen Stromabnehmer (117) der zweiten Elektrode, der elektrisch mit der zweiten Elektrode (116) verbunden ist, und
wobei der leitende Klebefilm (160) unmittelbar den Stromabnehmer (117) der zweiten Elektrode berührt.

12. Solarzellenmodul nach Anspruch 1, **dadurch gekennzeichnet, dass** die zweiten leitenden Teilchen (164b), die einander nicht in dem Überlappbereich überlappen, nicht in den Verbinder (120) und den Elektrodenabschnitt eingebettet sind.

## Revendications

1. Module de piles photovoltaïques comprenant :
une pluralité de piles photovoltaïques (110), chacune de la pluralité de piles photovoltaïques (110) incluant un substrat (111) et une partie d'électrodes positionnée sur le substrat (111) ;
un interconnecteur (120) configuré pour connecter électriquement des piles photovoltaïques (110) adjacentes de la pluralité de piles photovoltaïques les unes aux autres ; et
un film adhésif conducteur (160) positionné entre la partie d'électrodes de chaque pile photovoltaïque (110) et l'interconnecteur (120), le film adhésif conducteur (160) étant configuré pour connecter électriquement la partie d'électrodes de chaque pile photovoltaïque (110) à l'interconnecteur (120), le film adhésif conducteur (160) incluant une résine (162) ayant une première épaisseur (T1) dans une zone de chevauchement du film adhésif conducteur (160), de la partie d'électrodes et de l'interconnecteur (120), et ayant des particules conductrices (164), qui sont dispersées dans la résine (162),
dans lequel les particules conductrices (164) sont constituées de particules métalliques ayant une forme de radical, dans lequel la particule conductrice (164) ayant la forme de radical indique une particule dans laquelle une pluralité de projections sont formées de façon non uniforme sur la surface des particules métalliques ayant une forme comme une sphère,
dans lequel les particules conductrices (164) incluent des premières particules conductrices (164a) ayant des épaisseurs supérieures à la première épaisseur (T1), **caractérisé en ce que**
les particules conductrices (164) incluent en outre des deuxièmes particules conductrices (164b) ayant des épaisseurs inférieures à la première épaisseur (T1),
dans lequel les premières particules conductrices (164a) sont intégrées dans l'interconnecteur (120) et la partie d'électrodes, respectivement, et
dans lequel au moins deux deuxièmes particules conductrices (164b) parmi les deuxièmes particules se chevauchent dans la zone de chevauchement, et une somme des épaisseurs des deuxièmes particules conductrices (164b) se chevauchant est supérieure à la première épaisseur (T1).

2. Module de piles photovoltaïques selon la revendication 1, **caractérisé en ce qu'**une distance entre l'interconnecteur (120) et la partie d'électrodes est maintenue à la première épaisseur.

3. Module de piles photovoltaïques selon la revendication 1, **caractérisé en ce que** le substrat (111) a une épaisseur d'environ 80 µm à 180 µm.

4. Module de piles photovoltaïques selon la revendication 1, **caractérisé en ce que** les particules conductrices sont constituées de particules métalliques contenant au moins un métal choisi parmi le cuivre (Cu), l'argent (Ag), l'or (Au), le fer (Fe), le nickel (Ni), le plomb (Pb), le zinc (Zn), le cobalt (Co), le titane (Ti), et le magnésium (Mg) comme le composant principal.

5. Module de piles photovoltaïques selon la revendication 1, **caractérisé en ce que** l'interconnecteur (120) inclut un métal conducteur (122) constitué d'un matériau dépourvu de plomb contenant du plomb égal ou inférieur à environ 1 000 ppm ou ledit métal conducteur (122) et une brasure (124) constituée d'un matériau contenant du plomb déposé sur une surface du métal conducteur (122).

6. Module de piles photovoltaïques selon la revendication 1, **caractérisé en ce qu'**une surface de la partie d'électrodes est une surface régulière ou une surface irrégulière ayant une pluralité de parties irrégulières.

7. Module de piles photovoltaïques selon la revendication 1, **caractérisé en ce que** la partie d'électrodes (114) inclut une pluralité de premières électrodes (113) positionnées sur une première surface du substrat (111), et
dans lequel le film adhésif conducteur (160) est positionné dans un sens croisant la pluralité de premières électrodes (113) et recouvre une partie d'une surface supérieure et les deux côtés de chacune de la pluralité de premières électrodes (113) et un espace entre la pluralité de premières électrodes (113).

8. Module de piles photovoltaïques selon la revendication 7, **caractérisé en ce que** la résine (162) a une deuxième épaisseur supérieure à la première épaisseur dans une zone de non chevauchement entre le film adhésif conducteur (160) et la pluralité de premières électrodes (113), et l'épaisseur des premières particules conductrices (164a) est inférieure à la deuxième épaisseur.

9. Module de piles photovoltaïques selon la revendication 1, **caractérisé en ce que** la partie d'électrodes inclut une pluralité de premières électrodes (113) positionnées sur une première surface du substrat (111) et une pluralité de collecteurs (114) de courant de premières électrodes croisant la pluralité de premières électrodes (113), et
dans lequel le film adhésif conducteur (160) est positionné sur la pluralité de collecteurs (114) de courant de premières électrodes dans un sens parallèle à la pluralité de collecteurs (114) de courant de premières électrodes.

10. Module de piles photovoltaïques selon la revendication 7, **caractérisé en ce que** la partie d'électrodes inclut une deuxième électrode (116) positionnée sur une deuxième surface du substrat (111), et
dans lequel le film adhésif conducteur (160) contacte directement la deuxième électrode (116).

11. Module de piles photovoltaïques selon la revendication 9, **caractérisé en ce que** la partie d'électrodes inclut une deuxième électrode (116) positionnée sur une deuxième surface du substrat (111) et un collecteur (117) de courant de deuxième électrode électriquement connecté à la deuxième électrode (116), et
dans lequel le film adhésif conducteur (160) contacte directement le collecteur (117) de courant de deuxième électrode.

12. Module de piles photovoltaïques selon la revendication 1, **caractérisé en ce que** les deuxièmes particules conductrices (164b) qui ne se chevauchent pas dans la zone de chevauchement ne sont pas intégrées dans l'interconnecteur (120) et la partie d'électrodes.
